# EUROPEAN PATENT APPLICATION

(11) **EP 4 586 492 A1**
(43) Date of publication of application: **16.07.2025**
(21) Application number: 25150135.9
(22) Date of filing: 03.01.2025
(51) Int. Cl.: H02P 5/68

(54) **MULTI-AXIS DRIVE CONTROL CIRCUIT**

(30) Priority: 09.01.2024 CN 202420052733 U
(71) Applicant: Siemens Healthineers AG, 91301 Forchheim (DE)
(72) Inventor: DING, Zhu Gao, Shanghai, 201316 (CN); SUN, Zhi Wei, shang hai, 201318 (CN); ZHAI, Gang, shanghai, 201318 (CN); LIU, Bing, Shanghai, 201318 (CN); LIU, Lei, SHANG HAI, 201318 (CN); ZHANG, Ying, shang hai, 201318 (CN); MODEL, Volker, 90766 Fürth (DE); MEYNDT, Martin, 91080 Uttenreuth (DE)
(74) Representative: HKW Intellectual Property PartG mbB

(57) **Abstract**

Embodiments of the present application disclose a multi-axis drive control circuit. For multiple drive axes with no need for linkage of each phase, the multi-axis drive control circuit respectively comprises: a drive axis selection circuit unit, which is used for outputting a selection signal that enables a target drive axis; and a PWM signal multiplexing circuit unit, which is used, according to the selection signal, for causing a PWM signal output path of the target drive axis to be on, and causing PWM signal output paths of drive axes other than the target drive axis to be off. The technical solutions in embodiments of the present application can achieve multi-axis drive control in a situation where microprocessor resources are limited.

## Description

### TECHNICAL FIELD

The present disclosure relates to the technical field of control, in particular a multi-axis drive control circuit.

### BACKGROUND ART

At present, single-ended or complementary PWM signal drive is mostly used for common electric motor drive, and PWM resources inside a microprocessor are generally limited, in particular for the case of PWM complementary input, and often PWM resources are insufficient because of pin signal multiplexing inside the microprocessor. Furthermore, for multi-axis electric motor driving, that is, for the case of multi-axis PWM complementary input, the lack of PWM resources is even more prominent.

At present, multiple microcontrollers are generally used to respectively control electric motor drive along various specific axes, but this solution typically increases costs of a large amount of hardware. Alternatively, on-chip multiple PWM output signals are used to control electric motor drive, but when there is a lack of on-chip resources, this solution imperceptibly increases the workload of software design, and system robustness cannot be sufficiently ensured, causing much inconvenience for production and testing.

Therefore, those skilled in the art are still working toward seeking other solutions for multi-axis drive control.

### SUMMARY OF THE DISCLOSURE

In view of this, embodiments of the present disclosure propose a multi-axis drive control circuit, for achieving multi-axis drive control in a situation where microprocessor resources are limited.

A multi-axis drive control circuit proposed in embodiments of the present application, for multiple drive axes with no need for linkage of each phase, respectively comprises: a drive axis selection circuit unit, which is used for outputting a selection signal that enables a target drive axis; and a PWM signal multiplexing circuit unit, which is used, according to the selection signal, for causing a PWM signal output path of the target drive axis to be on, and causing PWM signal output paths of drive axes other than the target drive axis to be off.

In one embodiment, the multiple axes are two axes; the drive axis selection circuit unit comprises: one input end, which is used for receiving a target drive axis enabling signal; two output ends, of which a first output end is directly connected to the input end, to output a first level signal that matches the enabling signal; and a first NOT gate, which is connected between the input end and a second output end of the two output ends, to cause the second output end to output a second level signal that is opposite to the first level signal.

In one embodiment, the PWM signal multiplexing circuit unit comprises: two signal gating sub-circuits, wherein one signal gating sub-circuit is used for receiving a first combination as a selection signal that is formed by the first level signal and the second level signal of the two output ends of the drive axis selection circuit unit; and the other signal gating sub-circuit is used for receiving a second combination as a selection signal that is formed by the first level signal and the second level signal of the two output ends of the drive axis selection circuit unit; the two signal gating sub-circuits are used, respectively according to the received selection signals, for controlling the PWM signal output path of the drive axis corresponding thereto to be on or off.

In one embodiment, the PWM signals are complementary PWM signals; and each of the two signal gating sub-circuits comprises: a second NOT gate; a first NOR gate, of which one input end is connected to an output end of the second NOT gate; a first NAND gate, of which one input end is connected to an output end of the first NOR gate, and another input end is connected to a high-side PWM signal output end of the complementary PWM signals; an output end thereof acts as a high-side PWM signal selection output end; a second NAND gate, of which one input end is connected to an output end of the first NOR gate, and another input end is connected to a low-side PWM signal output end of the complementary PWM signals; an output end thereof acts as a low-side PWM signal selection output end; an input end of the second NOT gate of one of the signal gating sub-circuits is connected to the first output end of the drive axis selection circuit unit, and another input end of the first NOR gate is connected to the second output end of the drive axis selection circuit unit; an input end of the second NOT gate of the other signal gating sub-circuit is connected to the second output end of the drive axis selection circuit unit, and another input end of the first NOR gate is connected to the first output end of the drive axis selection circuit unit.

In one embodiment, the multi-axis drive control circuit further comprises: a low-side gate drive protection circuit unit provided for each drive axis, used for pulling up a low-side PWM signal when a target drive axis power supply voltage is abnormal or drive of the target drive axis is incorrectly reported.

In one embodiment, the low-side gate drive protection circuit unit comprises: a third NAND gate, of which one input end is connected to power supply voltage output feedback of a drive axis, and another input end is connected to drive axis drive fault feedback; a third NOT gate, of which one input end is connected to an output end of the third NAND gate; a second NOR gate, of which one input end is connected to an output end of the first NAND gate, and another input end is connected to an output end of the third NAND gate; an output end is connected to a drive axis drive chip; and a fourth NAND gate, of which one input end is connected to an output end of the second NAND gate, and another input end is connected to an output end of the third NOT gate; an output end is connected to the drive axis drive chip.

In one embodiment, the PWM signals are single-ended PWM signals; and each of the two signal gating sub-circuits comprises: a second NOT gate; a first NOR gate, of which one input end is connected to an output end of the second NOT gate; a first NAND gate, of which one input end is connected to an output end of the first NOR gate, and another input end is connected to a single-ended PWM signal output end; an output end thereof acts as the single-ended PWM signal selection output end; an input end of the second NOT gate of one of the signal gating sub-circuits is connected to the first output end of the drive axis selection circuit unit, and another input end of the first NOR gate is connected to the second output end of the drive axis selection circuit unit; an input end of the second NOT gate of the other signal gating sub-circuit is connected to the second output end of the drive axis selection circuit unit, and another input end of the first NOR gate is connected to the first output end of the drive axis selection circuit unit.

In one embodiment, the multiple axes are three or more axes; the drive axis selection circuit unit comprises: an encoder, and two or more input ends thereof are used for receiving two or more target drive axis enabling signals; each group of output ends thereof is used for a selection signal of one drive axis.

In one embodiment, the PWM signal multiplexing circuit unit is an integrated circuit with multiple outputs that are independently enabled.

It can be seen from the above solutions that in embodiments of the present disclosure, by providing a drive axis selection circuit unit and a PWM signal multiplexing circuit unit, multiplexing can be performed on limited resources of a microprocessor, so that multi-axis drive control can be achieved in a situation where microprocessor resources are limited.

In addition, the signal gating sub-circuit that is realized using logic gates has high precision, a low transmission delay and a low cost.

Furthermore, for complementary PWM signals, by providing a low-side gate drive protection circuit unit, a low-side PWM signal may be pulled up when a target drive axis power supply voltage is abnormal or drive of the target drive axis is incorrectly reported, to ensure backend low-side gate drive forward conduction, preventing damage to the drive end due to reverse flyback current.

### BRIEF DESCRIPTION OF THE DRAWINGS

Preferred embodiments of the present application are described in detail below with reference to the drawings, to give those skilled in the art a clearer understanding of the above and other features and advantages of the present application. In the drawings:
Fig. 1 is a demonstrative structural diagram of a multi-axis drive control circuit in an embodiment of the present disclosure.
Fig. 2 is a demonstrative structural diagram of a multi-axis drive control circuit in an example of the present disclosure.
Fig. 3 is a timing diagram based on the multi-axis drive control circuit shown in Fig. 2.

Key to the drawings:

| Label | Meaning |
|---|---|
| 11 | Drive axis selection circuit unit |
| 111 | First NOT gate |
| 12 | PWM signal multiplexing circuit unit |
| 121 | Signal gating sub-circuit |
| 1211 | Second NOT gate |
| 1212 | First NOR gate |
| 1213 | First NAND gate |
| 1214 | Second NAND gate |
| 13 | Low-side gate drive protection circuit unit |
| 131 | Third NAND gate |
| 132 | Third NOT gate |
| 133 | Second NOR gate |
| 134 | Fourth NAND gate |
| 14 | Power supply voltage safety functional circuit unit |
| 15 | Voltage conversion module |

### DETAILED DESCRIPTION OF EMBODIMENTS

In embodiments of the present application, in order to not increase hardware and software resources of a microprocessor, effective multiplexing of PWM signals is considered in a situation where microprocessor resources are limited, to achieve multi-axis drive control.

To enable a clearer understanding of the objective, technical solutions and effects of the present application, particular embodiments of the present application are now explained with reference to the accompanying drawings, in which identical labels indicate structurally identical components or components with similar structures but identical functions.

As used herein, "exemplary" and "schematic" mean "serving as an instance, example or illustration". No drawing or embodiment described herein as "exemplary" or "schematic" should be interpreted as a more preferred or more advantageous technical solution.

To make the drawings appear uncluttered, only those parts relevant to the present application are shown schematically in the drawings; they do not represent the actual structure thereof as a product.

In this text, "a" does not only mean "just this one"; it may also mean "more than one". In this text, "first", "second", etc. are merely used to differentiate between parts, not to indicate the order or degree of importance between parts, etc. In addition, a noun or pronoun referring to a person in the present disclosure is not limited to a specific gender.

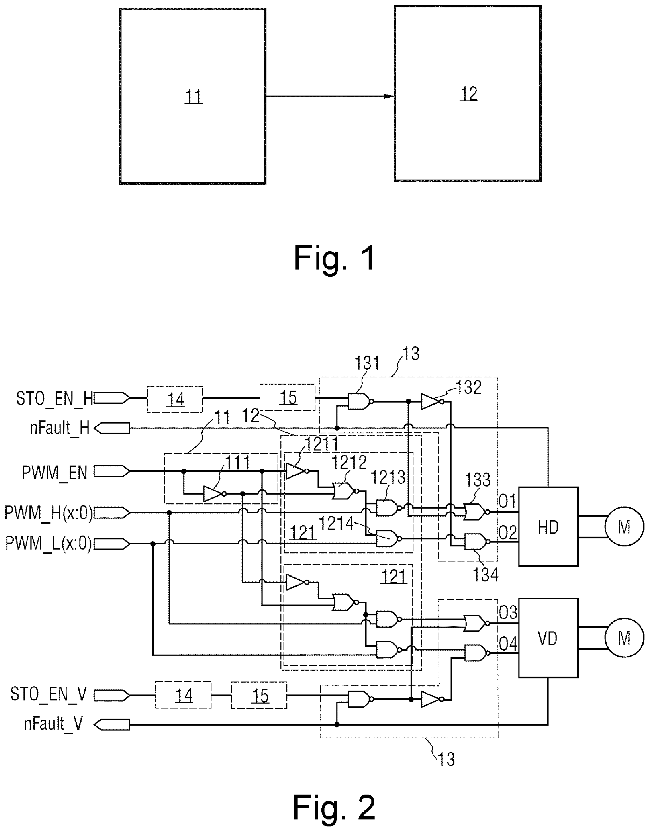

Fig. 1 is a demonstrative structural diagram of a multi-axis drive control circuit in an embodiment of the present disclosure. As shown in Fig. 1, the multi-axis drive control circuit may, for multiple drive axes with no need for linkage of each phase, respectively comprise: a drive axis selection circuit unit 11 and a PWM signal multiplexing circuit unit 12.

A drive axis selection circuit unit 11 is used for outputting a selection signal that enables a target drive axis.

A PWM signal multiplexing circuit unit 12 is used, according to the selection signal, for causing a PWM signal output path of the target drive axis to be on, and causing PWM signal output paths of drive axes other than the target drive axis to be off.

When specifically implemented, the drive axis selection circuit unit 11 and the PWM signal multiplexing circuit unit 12 may both have various forms of implementation.

Fig. 2 is a demonstrative structural diagram of a multi-axis drive control circuit in an example of the present disclosure. As shown in Fig. 2, the multiple axes in this example are two axes, that is, two-axis drive. In the present example, the drives of the two axes are respectively taken as drives of a horizontal drive axis and a vertical drive axis.

In this example, the drive axis selection circuit unit 11 comprises: an input end, two output ends and a first NOT gate 111.

The input end is used for receiving a target drive axis enabling signal PWM_EN. In the present example, a high level enables the horizontal drive axis, and a low level enables the vertical drive axis.

A first output end of the two output ends is directly connected to the input end, to output a first level signal that matches the enabling signal PWM_EN. For example, if the enabling signal PWM_EN is a high level, then the first output end outputs a high level; if the enabling signal PWM_EN is a low level, then the first output end outputs a low level.

The first NOT gate 111 is connected between the input end and a second output end of the two output ends, to cause the second output end to output a second level signal that is opposite to the first level signal. For example, if the enabling signal PWM_EN is a high level, then the second output end outputs a low level; if the enabling signal PWM_EN is a low level, then the second output end outputs a high level.

In the example shown in Fig. 2, the PWM signal multiplexing circuit unit 12 comprises: two signal gating sub-circuits 121, wherein one signal gating sub-circuit 121 is used for receiving a first combination as a selection signal that is formed by the first level signal and the second level signal of the two output ends of the drive axis selection circuit unit 11; and the other signal gating sub-circuit 121 is used for receiving a second combination as a selection signal that is formed by the first level signal and the second level signal of the two output ends of the drive axis selection circuit unit 11; the two signal gating sub-circuits 121 are used, respectively according to the received selection signals, for controlling the PWM signal output path of the drive axis corresponding thereto to be on or off.

In the present example, with PWM signals taken as complementary PWM signals, each of the two signal gating sub-circuits 121 comprises: a second NOT gate 1211, a first NOR gate 1212, a first NAND gate 1213 and a second NAND gate 1214.

An input end of the first NOR gate 1212 is connected to an output end of the second NOT gate 1211.

One input end of the first NAND gate 1213 is connected to an output end of the first NOR gate 1212, and another input end is connected to a high-side PWM signal PWM_H output end of the complementary PWM signals; an output end thereof acts as a high-side PWM signal selection output end.

One input end of the second NAND gate 1214 is connected to an output end of the first NOR gate 1212, and another input end is connected to a low-side PWM signal PWM_L output end of the complementary PWM signals; an output end thereof acts as a low-side PWM signal selection output end.

An input end of the second NOT gate 1211 of the signal gating sub-circuit 121 for the horizontal drive axis is connected to the first output end of the drive axis selection circuit unit 11, and another input end of the first NOR gate 1212 is connected to the second output end of the drive axis selection circuit unit 11.

An input end of the second NOT gate 1211 of the signal gating sub-circuit 121 for the vertical drive axis is connected to the second output end of the drive axis selection circuit unit 11, and another input end of the first NOR gate 1212 is connected to the first output end of the drive axis selection circuit unit 11.

In considering complementary PWM signal applications, when target drive axis power supply voltage is abnormal or drive of the target drive axis is incorrectly reported, when PWM signal input abruptly stops, the situation is avoided where a backend low-side MOSFET conducts to ground, and an electric motor coil generates negative inverted emf in a short time due to reverse flyback current, which can then damage a drive end. As shown in the example in Fig. 2, a low-side gate drive protection circuit unit 13 is further provided for each drive axis, used for pulling up a low-side PWM signal when a target drive axis power supply voltage is abnormal or drive of the target drive axis is incorrectly reported, to ensure backend low-side gate drive forward conduction, preventing damage to the drive end due to reverse flyback current.

As shown in Fig. 2, low-side gate drive protection circuit units 13 for the horizontal drive axis and the vertical drive axis both comprise: a third NAND gate 131, a third NOT gate 132, a second NOR gate 133 and a fourth NAND gate 134.

In the low-side gate drive protection circuit unit 13 for the horizontal drive axis, an input end of the third NAND gate 131 is connected to power supply voltage output feedback STO_EN_H of the horizontal drive axis, and another input end is connected to drive fault feedback nFault_H of the horizontal drive axis (in the present embodiment, analysis is given by taking an nFault_H signal to be active at a low level, and likewise for nFault_V below). In the low-side gate drive protection circuit unit 13 for the vertical drive axis, an input end of the third NAND gate 131 is connected to power supply voltage output feedback STO_EN_V of the vertical drive axis, and another input end is connected to drive fault feedback nFault_V of the vertical drive axis.

An input end of the third NOT gate 132 is connected to an output end of the third NAND gate 131.

One input end of the second NOR gate 133 is connected to an output end of a first NAND gate 1213 that acts as a high-side PWM signal selection output end, and another input end is connected to an output end of the third NAND gate 131; in the low-side gate drive protection circuit unit 13 for the horizontal drive axis, an output end O1 is connected to a drive chip HD of the horizontal drive axis; in the low-side gate drive protection circuit unit 13 for the vertical drive axis, an output end O3 is connected to a drive chip VD of the vertical drive axis.

One input end of the fourth NAND gate 134 is connected to an output end of a second NAND gate 1214 that acts as a low-side PWM signal selection output end, and another input end is connected to an output end of the third NAND gate 131; in the low-side gate drive protection circuit unit 13 for the horizontal drive axis, an output end O2 is connected to a drive chip HD of the horizontal drive axis; in the low-side gate drive protection circuit unit 13 for the vertical drive axis, an output end O4 is connected to a drive chip VD of the vertical drive axis.

When specifically implemented, the low-side gate drive protection circuit unit 13 may be jointly used for three-phase drive for each drive axis. Of course, one low-side gate drive protection circuit unit 13 may also be used independently for the drive of each phase.

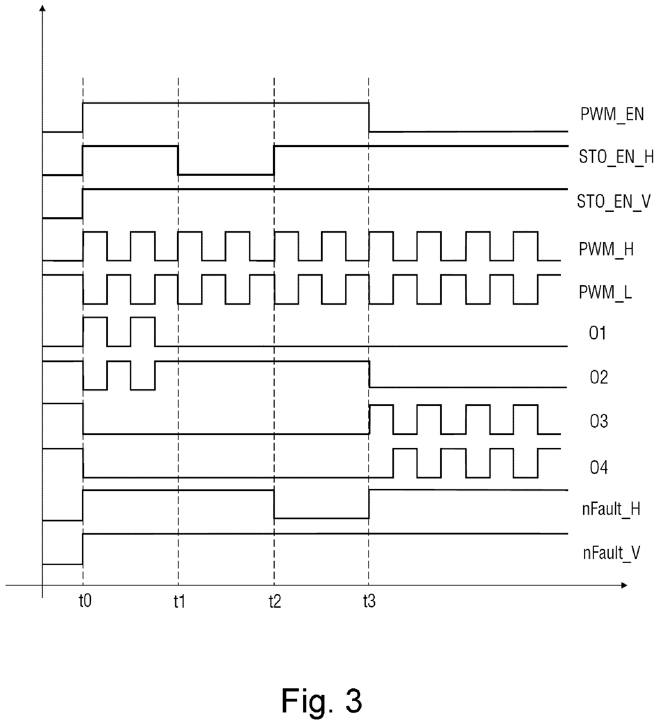

The timing diagram shown in Fig. 3 may be obtained on the basis of the example shown in Fig. 2. As shown in Fig. 3, in stage t0-t1, PWM_EN is a high level, that is, an enabling signal that enables a horizontal driver is output, and at the same time, power supply voltage output feedback STO_EN_H of the horizontal drive axis is normal (a high level is output), and output of complementary PWM signals PWM_H and PWM_L from a processor is normal; output of drive fault feedback nFault_H of the horizontal drive axis is normal (a high level is output, indicating that the drive chip is fault-free), and at this time, output ends O1 and O2 output complementary PWM signals normally. In stage t1-t2, PWM_EN is still a high level, that is, the enabling signal that enables the horizontal driver is still output, but power supply voltage output feedback STO_EN_H of the horizontal drive axis is abnormal (a low level is output), and at this time, although output of complementary PWM signals PWM_H and PWM_L from the processor is normal, the output ends O1 and O2 output non-complementary PWM signals, at which time the low-side PWM signal is pulled high, ensuring a backend low-side MOSFET conducts forward, preventing damage to a drive end due to reverse flyback current. In stage t2-t3, PWM_EN is still a high level, that is, the enabling signal that enables the horizontal driver is still output, but output of drive fault feedback nFault_H of the horizontal drive axis is abnormal (a low level is output, indicating that the drive chip is faulty), and at this time, although output of complementary PWM signals PWM_H and PWM_L from the processor is normal, the output ends O1 and O2 output non-complementary PWM signals, at which time the low-side PWM signal is pulled high, ensuring the backend low-side MOSFET conducts forward, preventing damage to a drive end due to reverse flyback current. In stage post-t3, PWM_EN is a low level, that is, an enabling signal that enables a vertical driver is output, and at the same time, power supply voltage output feedback STO_EN_V of the vertical drive axis is normal (a high level is output), and output of complementary PWM signals PWM_H and PWM_L from the processor is normal; output of drive fault feedback nFault_V of the vertical drive axis is normal (a high level is output, indicating that the drive chip is fault-free), and at this time, output ends O3 and O4 output complementary PWM signals normally.

In the above example shown in Fig. 2, a situation where the PWM signals are complementary PWM signals has been detailed. In other examples, the PWM signals may also be single-ended PWM signals. For the example shown in Fig. 2, if the complementary PWM signals are replaced with single-ended PWM signals, then each of the two signal gating sub-circuits 121 may only comprise: a second NOT gate 1211, a first NOR gate 1212 and a first NAND gate 1213.

An input end of the first NOR gate 1212 is connected to an output end of the second NOT gate 1211.

An input end of the first NAND gate 1213 is connected to an output end of the first NOR gate 1212, and another input end is connected to a single-ended PWM signal output end; and an output end thereof acts as the single-ended PWM signal selection output end.

An input end of the second NOT gate 1211 of the signal gating sub-circuit 121 for the horizontal drive axis is connected to the first output end of the drive axis selection circuit unit 11, and another input end of the first NOR gate 1212 is connected to the second output end of the drive axis selection circuit unit 11.

An input end of the second NOT gate 1211 of the signal gating sub-circuit 121 for the vertical drive axis is connected to the second output end of the drive axis selection circuit unit 11, and another input end of the first NOR gate 1212 is connected to the first output end of the drive axis selection circuit unit 11.

When the PWM signals are single-ended PWM signals, the circuit does not include the low-side gate drive protection circuit unit 13 described above.

In addition, in another embodiment, the multi-axis drive may also be drive of another number of axes, such as three axes, four axes or more axes, etc.

The multiple axes are three or more axes; another logic gate circuit may be used for the drive axis selection circuit unit, or an encoder may also be used, and two or more input ends thereof are used for receiving two or more target drive axis enabling signals; each group of output ends thereof is used for a selection signal of one drive axis. For example, when the multiple axes are three axes or four axes, another logic gate circuit may be used for the drive axis selection circuit unit, or, in an inclusive but non-limiting manner, a two-to-four decoder or a three-to-eight decoder, etc. may also be used. For example, two input ends of a two-to-four decoder are used for receiving two target drive axis enabling signals; each group of output ends thereof is used for a selection signal of one drive axis. When the multiple axes are more than this, a three-to-eight decoder, etc. may also be used. For example, three input ends of a three-to-eight decoder are used for receiving three target drive axis enabling signals; each group of output ends thereof is used for a selection signal of one drive axis.

In addition, as well an implementation form similar to the signal gating sub-circuit 121 shown in Fig. 2 being usable for the PWM signal multiplexing circuit unit, an integrated circuit or chip, etc. with multiple outputs that are independently enabled may also be used.

In addition, the multi-axis drive control circuit in an embodiment of the present disclosure may further comprise, as shown in Fig. 2, a power supply voltage safety functional circuit unit 14 further provided for each drive axis, used for providing a safe power supply voltage for the drive axis.

Additionally, when an external voltage and a system voltage do not match, such as when the external voltage is 5 V and the system voltage is 3.3 V, a voltage conversion module 15 may also be further provided for each drive axis, for converting a voltage to a voltage matching the drive axis.

It can be seen from the above solutions that in embodiments of the present disclosure, by providing a drive axis selection circuit unit and a PWM signal multiplexing circuit unit, multiplexing can be performed on limited resources of a microprocessor, so that multi-axis drive control can be achieved in a situation where microprocessor resources are limited.

In addition, the signal gating sub-circuit that is realized using logic gates has high precision, a low transmission delay and a low cost.

Furthermore, for complementary PWM signals, by providing a low-side gate drive protection circuit unit, a low-side PWM signal may be pulled up when a target drive axis power supply voltage is abnormal or drive of the target drive axis is incorrectly reported, to ensure backend low-side gate drive forward conduction, preventing damage to the drive end due to reverse flyback current.

The embodiments above are merely preferred embodiments of the present application, which are not intended to limit it. Any amendments, equivalent substitutions or improvements, etc. made within the spirit and principles of the present application shall be included in the scope of protection thereof.

## Claims

1. A multi-axis drive control circuit, wherein for multiple drive axes with no need for linkage of each phase, the multi-axis drive control circuit respectively comprises:
a drive axis selection circuit unit, which is used for outputting a selection signal that enables a target drive axis; and
a PWM signal multiplexing circuit unit, which is used, according to the selection signal, for causing a PWM signal output path of the target drive axis to be on, and causing PWM signal output paths of drive axes other than the target drive axis to be off.

2. The multi-axis drive control circuit as claimed in claim 1, wherein the multiple axes are two axes; and the drive axis selection circuit unit comprises:
one input end, which is used for receiving a target drive axis enabling signal;
two output ends, of which a first output end is directly connected to the input end, to output a first level signal that matches the enabling signal; and
a first NOT gate, which is connected between the input end and a second output end of the two output ends, to cause the second output end to output a second level signal that is opposite to the first level signal.

3. The multi-axis drive control circuit as claimed in claim 2, wherein the PWM signal multiplexing circuit unit comprises: two signal gating sub-circuits, wherein one signal gating sub-circuit is used for receiving a first combination as a selection signal that is formed by the first level signal and the second level signal of the two output ends of the drive axis selection circuit unit; and the other signal gating sub-circuit is used for receiving a second combination as a selection signal that is formed by the first level signal and the second level signal of the two output ends of the drive axis selection circuit unit; the two signal gating sub-circuits are used, respectively according to the received selection signals, for controlling the PWM signal output path of the drive axis corresponding thereto to be on or off.

4. The multi-axis drive control circuit as claimed in claim 3, wherein the PWM signals are complementary PWM signals; and each of the two signal gating sub-circuits comprises:
a second NOT gate;
a first NOR gate, of which one input end is connected to an output end of the second NOT gate;
a first NAND gate, of which one input end is connected to an output end of the first NOR gate, and another input end is connected to a high-side PWM signal output end of the complementary PWM signals; an output end thereof acts as a high-side PWM signal selection output end;
a second NAND gate, of which one input end is connected to an output end of the first NOR gate, and another input end is connected to a low-side PWM signal output end of the complementary PWM signals; an output end thereof acts as a low-side PWM signal selection output end;
an input end of the second NOT gate of one of the signal gating sub-circuits is connected to the first output end of the drive axis selection circuit unit, and another input end of the first NOR gate is connected to the second output end of the drive axis selection circuit unit;
an input end of the second NOT gate of the other signal gating sub-circuit is connected to the second output end of the drive axis selection circuit unit, and another input end of the first NOR gate is connected to the first output end of the drive axis selection circuit unit.

5. The multi-axis drive control circuit as claimed in claim 4, wherein the multi-axis drive control circuit further comprises: a low-side gate drive protection circuit unit provided for each drive axis, used for pulling up a low-side PWM signal when a target drive axis power supply voltage is abnormal or drive of the target drive axis is incorrectly reported.

6. The multi-axis drive control circuit as claimed in claim 5, wherein the low-side gate drive protection circuit unit comprises:
a third NAND gate, of which one input end is connected to power supply voltage output feedback of a drive axis, and another input end is connected to drive axis drive fault feedback;
a third NOT gate, of which one input end is connected to an output end of the third NAND gate;
a second NOR gate, of which one input end is connected to an output end of the first NAND gate, and another input end is connected to an output end of the third NAND gate; an output end is connected to a drive axis drive chip; and
a fourth NAND gate, of which one input end is connected to an output end of the second NAND gate, and another input end is connected to an output end of the third NOT gate; an output end is connected to the drive axis drive chip.

7. The multi-axis drive control circuit as claimed in claim 3, wherein the PWM signals are single-ended PWM signals; and each of the two signal gating sub-circuits comprises:
a second NOT gate;
a first NOR gate, of which one input end is connected to an output end of the second NOT gate;
a first NAND gate, of which one input end is connected to an output end of the first NOR gate, and another input end is connected to a single-ended PWM signal output end; an output end thereof acts as the single-ended PWM signal selection output end;
an input end of the second NOT gate of one of the signal gating sub-circuits is connected to the first output end of the drive axis selection circuit unit, and another input end of the first NOR gate is connected to the second output end of the drive axis selection circuit unit;
an input end of the second NOT gate of the other signal gating sub-circuit is connected to the second output end of the drive axis selection circuit unit, and another input end of the first NOR gate is connected to the first output end of the drive axis selection circuit unit.

8. The multi-axis drive control circuit as claimed in claim 1, wherein the multiple axes are three or more axes; and the drive axis selection circuit unit comprises:
a decoder, of which two or more input ends are used for receiving two or more target drive axis enabling signals; each group of output ends thereof is used for a selection signal of one drive axis.

9. The multi-axis drive control circuit as claimed in claim 1, wherein the PWM signal multiplexing circuit unit is an integrated circuit with multiple outputs that are independently enabled.

10. The multi-axis drive control circuit as claimed in any one of claims 1 to 9, wherein the multi-axis drive control circuit further comprises: a power supply voltage safety functional circuit unit provided for each drive axis, used for providing a safe power supply voltage for the drive axis.
